# FASCICULE DE BREVET EUROPEEN

(11) **EP 3 931 507 B1**
(45) Date de publication et mention de la délivrance du brevet: **13.09.2023**
(21) Numéro de dépôt: 20725809.6
(22) Date de dépôt: 02.03.2020
(51) Int. Cl.: F28D 1/03, F28F 9/02, H01M 10/6556, F28F 3/12

(54) **DISPOSITIF DE REGULATION THERMIQUE, NOTAMMENT DE REFROIDISSEMENT POUR VEHICULE AUTOMOBILE**
TEMPERATURREGELVORRICHTUNG, INSBESONDERE EINE KÜHLVORRICHTUNG FÜR EIN KRAFTFAHRZEUG
TEMPERATURE CONTROL DEVICE, IN PARTICULAR COOLING DEVICE FOR A MOTOR VEHICLE

(30) Priorité: 01.03.2019 FR 1902122
(43) Date de publication de la demande: 05.01.2022
(73) Titulaire: VALEO SYSTEMES THERMIQUES, 78320 Le Mesnil Saint-Denis (FR)
(72) Inventeur: DJALLAL, Fethy, 72210 LA SUZE SUR SARTHE (FR); VERON, Julien, 72210 LA SUZE SUR SARTHE (FR); BELLENFANT, Aurélie, 72210 LA SUZE SUR SARTHE (FR); HERRY, Marc, 72210 LA SUZE SUR SARTHE (FR)
(74) Mandataire: Valeo Systèmes Thermiques
(86) Numéro de dépôt international: PCT/FR2020/050417
(87) Numéro de publication internationale: WO 2020/178519

(56) Documents cités:
- DE-A1-102008 059 955
- US-A1- 2016 172 726
- US-A1- 2016 356 558

## Description

La présente invention concerne un dispositif de régulation thermique, notamment de refroidissement, notamment pour composant électrique susceptible de dégager de la chaleur lors de son fonctionnement, notamment un dispositif de refroidissement d'au moins une batterie ou cellules de batterie de véhicule US 2016/172726 A1, qui peut être considéré comme l'art antérieur le plus proche, divulgue un dispositif de régulation thermique comportant une plaque supérieure et une plaque inférieure assemblée avec la plaque supérieure pour former ensemble une pluralité de canaux.

Les batteries de véhicules, en particulier pour véhicules électriques ou véhicules hybrides, doivent autant que possible être maintenues à température souhaitée, raison pour laquelle on utilise des dispositifs dits de refroidissement pour batteries de véhicules. Ces dispositifs de refroidissement peuvent comprendre des plaques de refroidissement à travers lesquelles circule un liquide de refroidissement. Les plaques de refroidissement sont installées, autant que possible sans espace, sur le côté extérieur des batteries dans le but de dissiper la chaleur ou bien de chauffer la batterie. On connaît des dispositifs de refroidissement dans lesquels la plaque de refroidissement est composée de deux parties de plaque qui sont normalement fixées directement l'une à l'autre. Ici, la première partie de plaque est de préférence plane, et la seconde partie de plaque est de préférence une feuille de métal emboutie ou déformée qui présente des dépressions en méandres. Lesdites dépressions sont fermées par la partie de plaque plane qui est fixée à la partie de plaque emboutie, de sorte que des conduits de réfrigérant sont formés. Le brevet EP 2 828 922 B1 décrit un tel dispositif.

On peut également citer la demande de brevet US2015144314 qui décrit un dispositif de refroidissement de batterie avec une bride de connexion de fluide.

L'invention vise à améliorer ce type de dispositif.

L'invention propose ainsi un dispositif de régulation thermique selon la revendication 1, notamment de refroidissement, pour composant électrique susceptible de dégager de la chaleur lors de son fonctionnement, notamment pour un module de stockage d'énergie électrique, ce dispositif comportant une plaque supérieure et une plaque inférieure assemblée avec la plaque supérieure pour former ensemble une pluralité de canaux de circulation pour un fluide caloporteur, notamment un fluide réfrigérant, notamment un fluide choisi parmi les fluides réfrigérants suivants R134a, R1234yf ou R744, dispositif dans lequel les canaux sont regroupés par groupes de canaux, les canaux d'un groupe s'étendant sensiblement parallèlement les uns aux autres avec un espacement prédéterminé entre canaux voisins appelé espacement intra-groupe, deux groupes de canaux ayant un même sens de circulation de fluide étant séparés entre eux par au moins un groupe de canaux ayant un sens de circulation de fluide opposé, le dispositif comportant un connecteur assemblé sur la plaque supérieure ou inférieure, et agencé pour créer un chemin de fluide pour raccorder deux zones collectrices, notamment des zones collectrices de sortie, de deux groupes de canaux ayant notamment le même sens de circulation, ces zones collectrices étant formées entre les deux plaques inférieure et supérieure, ce connecteur comportant un orifice externe d'entrée de fluide et un orifice externe de sortie de fluide, l'un de ces deux orifices externes étant en communication de fluide avec le chemin de fluide du connecteur et l'autre des orifices externes étant en communication de fluide avec une zone collectrice de fluide d'un groupe intermédiaire de canaux situé entre les deux groupes de canaux reliés entre eux par le chemin de fluide dans le connecteur, ce groupe intermédiaire ayant notamment un sens de circulation de sens opposé aux deux autres groupes, le ou les groupes de canaux pouvant être, le cas échéant, réduit, en nombre, à seul un canal.

L'invention permet notamment, pour un packaging réduit et un minimum de composants, à partir d'une connexion entrée / sortie fluide, d'évacuer ou alimenter le fluide dans deux zones non adjacentes du circuit du dispositif de régulation thermique, qui définit notamment un échangeur thermique, et d'alimenter respectivement évacuer, une zone du circuit de l'échangeur se trouvant entre ces deux zones adjacentes.

L'invention permet en outre, par exemple dans le cadre d'un échangeur brasé comportant une plaque supérieure, une plaque inférieure, et des canaux de fluide entre les deux plaques, de transférer via le condit de jonction le fluide d'une zone de fluide de l'échangeur vers une autre zone de fluide non adjacente de cet échangeur. Ce conduit peut être de forme tubulaire, étant par exemple un tube de section ovale ou ronde ou de section rectangle ou carrée, ce tube étant agencé pour relier les deux zones non adjacentes à alimenter en fluide ou à évacuer en fluide,

L'invention permet notamment de réaliser un échangeur thermique de refroidissement à plaques pour batteries. Cet échangeur de préférence fait partie d'une boucle avec réfrigérant ou liquide.

L'invention permet notamment la réalisation d'un circuit d'un dispositif à plaques destiné à satisfaire les critères d'homogénéité de température dans un module de batterie et entre les modules dans lequel il est nécessaire à partir d'une connexion entrée! sortie fluide, de faire évacuer, ou alimenter ce fluide de deux zones non adjacentes du circuit de l'échangeur et d'alimenter, ou respectivement évacuer du fluide, une zone se trouvant entre ces deux zones non adjacentes.

L'invention, en prévoyant le chemin de fluide entre deux orifices internes, ce chemin faisant office de pont de jonction de fluide entre deux zones, permet de n'avoir qu'un seul connecteur, ou bride, au lieu de deux brides simples.

Selon l'invention, le connecteur comporte deux orifices internes sur lesquels débouchent le chemin de fluide du connecteur, chemin qui en outre communique avec l'un des orifices externes, ces orifices internes étant placés en vis-à-vis respectivement de deux trous dans la plaque, trous qui débouchent de préférence sur les zones collectrices associées, et le connecteur comporte un troisième orifice interne qui communique avec l'autre des orifices externes via un canal dans le connecteur, canal notamment de forme cylindrique, ce troisième orifice interne étant placé de préférence en vis-à-vis d'un trou dans la plaque qui débouche sur la zone collectrice du groupe intermédiaire de canaux. Dans un exemple de l'invention, le connecteur comporte ainsi en tout 5 orifices.

Selon un aspect de l'invention, les orifices internes sont sur une même face du connecteur, face venant en contact avec la plaque, et les orifices externes sont notamment sur une face opposée du connecteur notamment de manière à permettre de raccorder sur ces orifices externes des conduits externes, l'un apportant du fluide et l'autre l'évacuant.

Selon un aspect de l'invention, le chemin de fluide comporte un tronçon principal perpendiculaire au canal débouchant sur le troisième orifice interne, ce tronçon et ce canal étant séparé l'un de l'autre.

Selon l'un des aspects de l'invention, le chemin de fluide est formé par une rainure réalisée sur un corps du connecteur et fermé par un capot fixé de manière étanche sur le corps, ce capot étant notamment de forme allongée.

Selon l'un des aspects de l'invention, le capot comporte une plaque agencée pour se loger au moins partiellement dans la rainure, ce capot étant par exemple soudé sur le corps.

Selon l'un des aspects de l'invention, le capot comporte une patte, notamment de forme rectangulaire, se loger dans une encoche de forme complémentaire de la patte.

De préférence, le capot comporte deux oreilles de fixation agencées pour venir en appui notamment sur deux faces latérales du corps et ces oreilles sont notamment poinçonnées sur le corps.

Selon l'un des aspects d l'invention, le corps du connecteur est réalisé notamment en aluminium, notamment par moulage et usinage, et le capot est réalisé de préférence en aluminium.

Selon l'un des aspects d l'invention, la plaque supérieure comporte trois trous, deux des trous étant associé à des groupes de canaux de même sens de circulation et un trou intermédiaire, entre ces deux trous, qui est associé à un groupe de canaux de fluide de sens opposé, ces trois trous étant notamment alignés.

Les caractéristiques et avantages de l'invention apparaîtront plus clairement à la lecture de la description suivante, donnée à titre d'exemple illustratif et non limitatif, et des dessins annexés parmi lesquels :
- la [Figure 1] illustre, schématiquement et partiellement, un dispositif selon un exemple de l'invention ;
- la [Figure 2] illustre, schématiquement et partiellement, le dispositif de la [Figure 1] selon une vue différente,
- la [Figure 3] illustre, schématiquement et partiellement, un dispositif selon un autre exemple de l'invention,
- la [Figure 4] illustre, schématiquement et partiellement, le dispositif de la [Figure 3] selon une vue différente,
- la [Figure 5] illustre, schématiquement et partiellement, un connecteur d'un dispositif selon un exemple de l'invention,
- la [Figure 6] illustre, schématiquement et partiellement, le connecteur de la [Figure 5] selon une vue différente,
- la [Figure 7] illustre, schématiquement et partiellement, un connecteur selon un autre exemple de l'invention,
- la [Figure 8] illustre, schématiquement et partiellement, le connecteur de la [Figure 7] selon une vue différente.

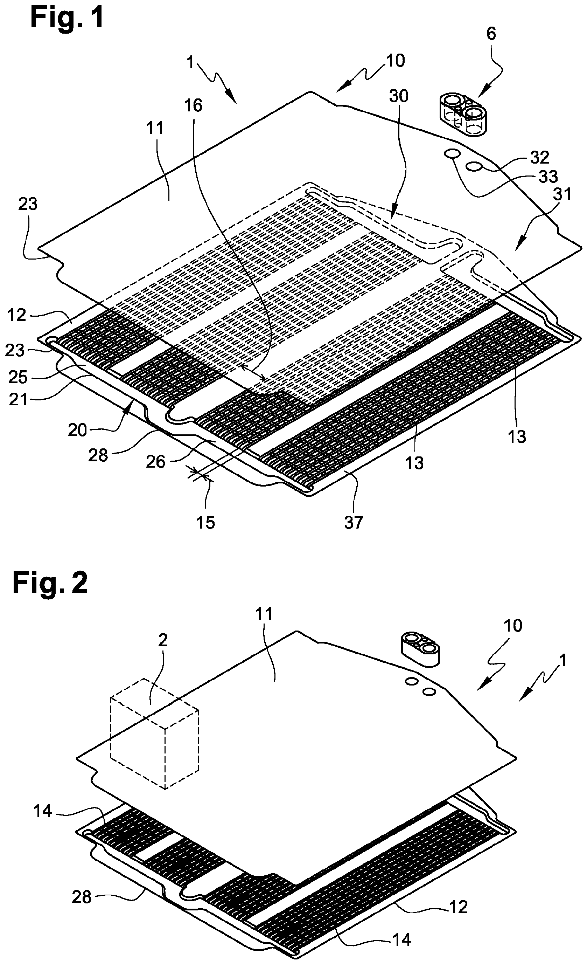

On a représenté sur la [Figure 1] et sur la [Figure 2] un système 1 comportant un ensemble de cellules de batterie 2 à refroidir, par exemple rangées suivant deux rangées ou plus, et un dispositif de refroidissement 10 agencé pour refroidir les cellules 2, qui sont en contact thermique avec une plaque supérieure du dispositif de refroidissement 10, comme expliqué plus bas.

Le dispositif de régulation thermique 10 comporte une plaque supérieure 11, une plaque inférieure 12 assemblée avec la plaque supérieure 11 pour former ensemble une pluralité de canaux 13 de circulation pour un fluide caloporteur, notamment un fluide réfrigérant, notamment un fluide choisi parmi les fluides réfrigérants suivants R134a, R1234yf ou R744. Les canaux 13 sont regroupés par groupes 14 de canaux, les canaux d'un groupe s'étendant sensiblement parallèlement les uns aux autres avec un espacement prédéterminé entre canaux voisins appelé espacement intra-groupe 15, l'espacement intra-groupe étant strictement inférieur à l'espacement entre deux groupes de canaux voisins appelé espacement intergroupe 16. Les canaux 13 présentent chacun une section transversale comprise entre 1 mm2 et 9 mm2. Les canaux 13 présentent tous une même section transversale et sont rectilignes. Les canaux 13 s'étendent sensiblement sur toute la longueur des plaques. Les groupes 14 de canaux sont disposés côte à côte et présentent la même longueur. L'espacement intra-groupe 15 entre les différents canaux 13 d'un même groupe de canaux est constant, dans l'exemple considéré. L'espacement intergroupe 16 entre les différents groupes de canaux est constant, dans l'exemple considéré. Le dispositif de refroidissement comporte une chambre de virage 20 agencée pour conduire le fluide sortant de l'un des groupes 14 de canaux vers l'un des autres groupes de canaux. Tous les canaux 13 du groupe débouchent sur cette chambre de virage. La chambre de virage 20 est formée par les plaques supérieure 11 et inférieure 12, par exemple en aluminium. La plaque inférieure 12 comporte une zone emboutie 21 agencée pour participer à la formation de la chambre de virage 20. La zone emboutie 21 est fermée avec l'autre des plaques 11 qui est plane pour former la chambre de virage 20. La chambre de virage 20 s'étend sur un côté 23 des plaques. Le dispositif comporte quatre groupes 14 de canaux. Le nombre de groupe de canaux dédiés à une circulation de fluide réfrigérant dans un sens est égal au nombre de groupes de canaux dédiés à la circulation de fluide dans le sens opposé. Deux groupes 14 de canaux de même sens de circulation de fluide débouchent sur la chambre de virage. Ces deux groupes de canaux sont voisins, sur une moitié des plaques. La chambre de virage 20 est connectée fluidiquement à deux autres groupes 14 de canaux qui sont agencés pour accueillir le fluide réfrigérant qui quittent la chambre de virage. Ces deux groupes de canaux sont voisins sur l'autre moitié des plaques. Ainsi quatre groupes de canaux sont reliés à la chambre de virage commune 20. Les deux groupes 14 de canaux d'arrivée sur la chambre de virage 20 sont disposés sur une branche 25 de la chambre de virage et les deux groupes de canaux de sortie de la chambre de virage sont disposés sur une autre branche 26 de la chambre de virage. Le sens de circulation des fluides est montré par des flèches. Ces branches 25 et 26 de la chambre de virage 20 ont sensiblement rectilignes, et perpendiculaires aux canaux. Un coude 28 est agencé pour relié les deux branches 25 et 26 de la chambre de virage. Le dispositif de refroidissement comporte une zone d'entrée 30 de fluide réfrigérant des canaux, cette zone d'entrée étant formée entre les deux plaques 11 et 12. Cette zone d'entrée 30 de fluide est agencée pour alimenter tous les canaux 13 de circulation de fluide qui débouchent sur la chambre de virage 20, à savoir les canaux dans lesquels le fluide s'écoule vers la chambre de virage. Cette zone d'entrée 30 est commune aux groupes 14 de canaux. Le dispositif de refroidissement comporte une zone de sortie 31 de fluide réfrigérant des canaux, cette zone de sortie étant formée entre les deux plaques 11 et 12. Cette zone de sortie 31 de fluide est agencée pour conduire le fluide sortant de tous les canaux 13 de circulation de fluide qui proviennent de la chambre de virage. Cette zone de sortie 31 est commune aux deux groupes de canaux. Les zones d'entrée 30 et 31 et de sortie sont adjacentes à un orifice d'entrée 32, respectivement de sortie 33. Les orifices d'entrée 32 et de sortie 33 sont reliés à un bloc de raccord 6 de tubulures. La plaque inférieure 2 comporte des zones de section transversale arrondie, notamment des zones embouties, pour former avec la plaque supérieure les canaux 13. Les zones d'entrée 30 et de sortie 31 comportent des zones embouties de la plaque inférieure 12. Préférentiellement le fluide caloporteur peut être choisi parmi les fluides réfrigérants d'appellation R134a, R1234yf ou R744. Le fluide caloporteur utilisé est alternativement de l'eau glycolée, sans limitation du titre de glycol (0% à 100%). Les cellules de batterie comprennent par exemple une pluralité de batteries au lithium-ion (Li-ion) pour une utilisation dans un véhicule hybride. Dans un autre mode de réalisation, la pluralité de cellules de batterie sont des batteries Li-ion pour une utilisation dans un véhicule électrique à batterie. La chambre de virage 20 et/ou la zone d'entrée 30 et/ou la zone de sortie 31 comportent, le cas échéant, des éléments de renfort pour renforcer la tenue mécanique dans ces zones qui sont potentiellement de plus forte section.

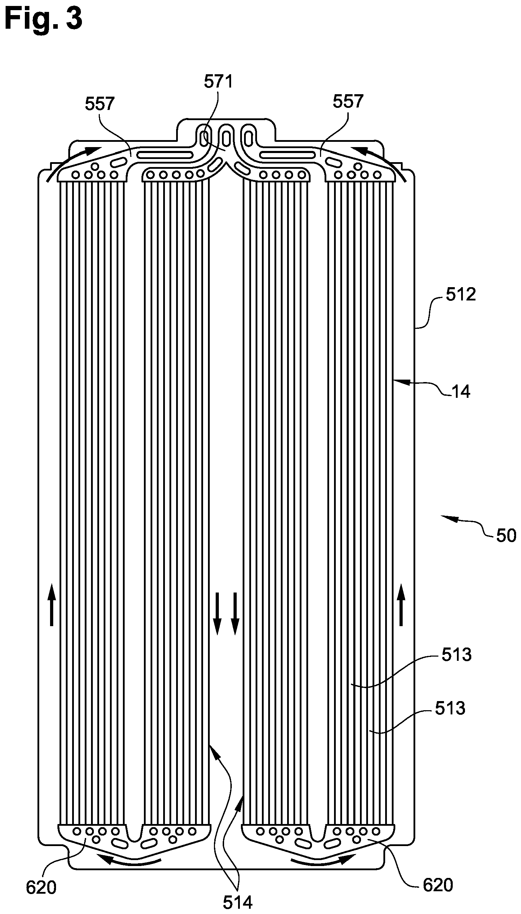

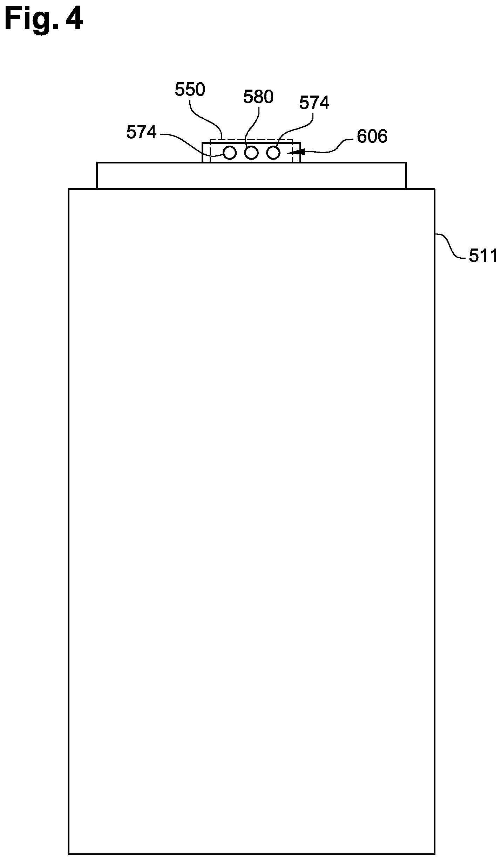

On a représenté en référence à la [Figure 3] et à la [Figure 4], un autre mode de réalisation de l'invention, à savoir un dispositif de régulation thermique 50, ici de refroidissement, pour un module de stockage d'énergie électrique, ce dispositif comportant une plaque supérieure 511 et une plaque inférieure 512 assemblée avec la plaque supérieure 511 pour former ensemble une pluralité de canaux 513 de circulation pour un fluide caloporteur, dispositif dans lequel les canaux sont regroupés par groupes 14 de canaux, les canaux d'un groupe s'étendant sensiblement parallèlement les uns aux autres avec un espacement prédéterminé entre canaux voisins, deux groupes 14 de canaux ayant un même sens de circulation de fluide étant séparés entre eux par deux groupes 614 voisins de canaux ayant un sens de circulation de fluide opposé.

Des chambres de virage 620 sont prévus, à l'une des extrémités des canaux 13, pour raccorder par un virage à 180° l'un des groupes de canaux 14 au groupe de de canaux 614 voisin.

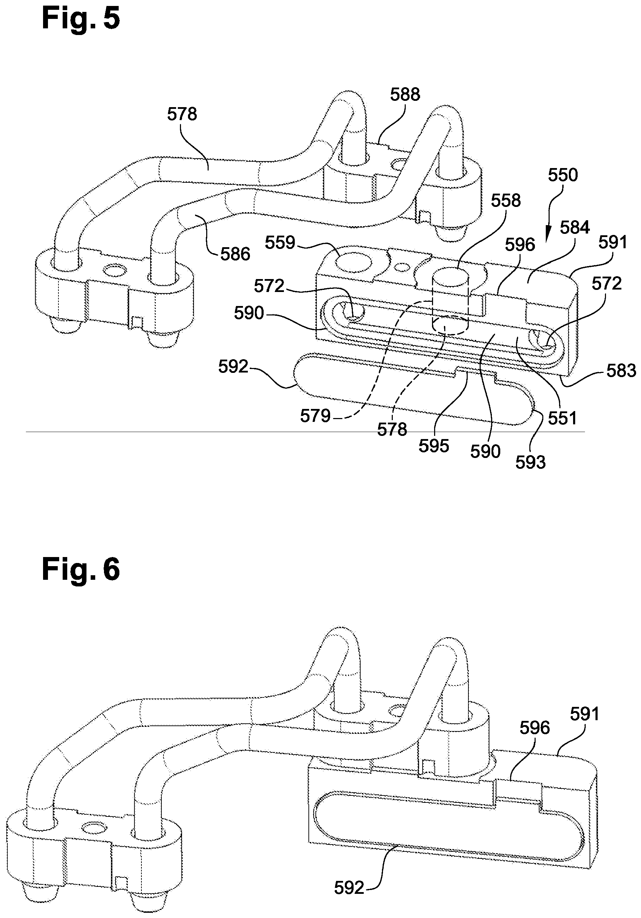

Le dispositif 50 comportant un connecteur 550 assemblé sur la plaque supérieure 511, comme illustré sur la [Figure 4] et sur la [Figure 5] ainsi que sur la [Figure 6].

Ce connecteur 550 est agencé pour créer un chemin de fluide 551 pour raccorder deux zones collectrices de sortie 557 des deux groupes de canaux 14 ayant le même sens de circulation illustré par flèches, ces zones collectrices 557 étant formées entre les deux plaques inférieure 512 et supérieure 511, ce connecteur 550 comportant un orifice externe d'entrée 558 de fluide et un orifice externe de sortie 559 de fluide, l'orifice externe de sortie 559 étant en communication de fluide avec le chemin de fluide 551 du connecteur et l'autre des orifice externe 558 étant en communication de fluide avec une zone collectrice 571 de fluide du groupe intermédiaire 614 de canaux situé entre les deux groupes de canaux 14 reliés entre eux par le chemin de fluide 551 dans le connecteur 50.

Le connecteur 50 comporte deux orifices internes 572 sur lesquels débouchent le chemin de fluide 551 du connecteur, chemin qui en outre communique avec l'orifice externe 559, ces orifices internes 572 étant placés en vis-à-vis respectivement de deux trous 574 dans la plaque 511, trous qui débouchent sur les zones collectrices associées 557, et le connecteur 550 comporte un troisième orifice interne 578 qui communique avec l'autre des orifices externes 558 via un canal droit cylindrique 579 dans le connecteur, ce troisième orifice 558 interne étant placé en vis-à-vis d'un trou 580 dans la plaque 511 qui débouche sur la zone collectrice 571 du groupe intermédiaire de canaux. Dans un exemple de l'invention, le connecteur 550 comporte ainsi en tout cinq orifices, à savoir 558, 559, 572 en deux exemplaires et 578.

Les orifices internes 572 et 578 sont sur une même face 583 du connecteur, face venant en contact avec la plaque, et les orifices externes 558 et 559 sont sur une face opposée 584 du connecteur de manière à permettre de raccorder sur ces orifices externes des conduits externes 586 et 587, l'un 586 apportant du fluide et l'autre 587 l'évacuant. Ces conduits sont fixés à une bride 588 commune, et se raccordent à une boucle de fluide.

Le chemin de fluide 551 comporte un tronçon principal 590 perpendiculaire au canal 579 débouchant sur le troisième orifice interne 578, ce tronçon rectiligne 590 et ce canal 579 étant séparés l'un de l'autre.

Le chemin de fluide 551 est formé par une rainure 590 creusée sur un corps 591 du connecteur et fermé par un capot 592 fixé de manière étanche sur le corps, ce capot 592 étant de forme allongée correspondant sensiblement la gorge de la rainure 590.

Le capot 592 comporte une plaque 593 agencée pour se loger au moins partiellement dans la rainure 590, ce capot 592 étant par exemple soudé sur le corps 591.

Le capot 592 comporte une patte 595, de forme rectangulaire, se loger dans une encoche 596 de forme complémentaire de la patte.

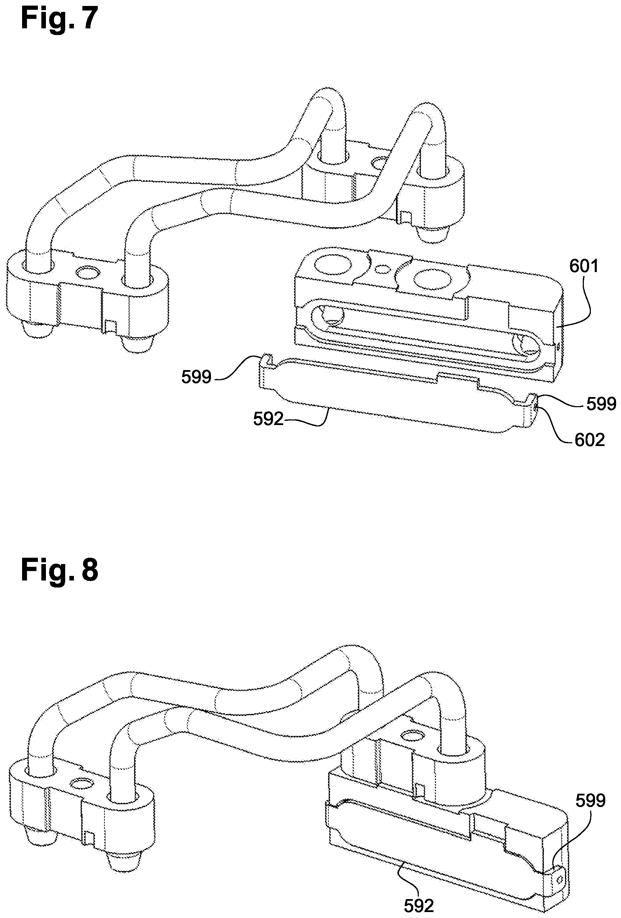

En variante, comme illustré sur la [Figure 7] et sur la [Figure 8], le capot 592 comporte deux oreilles de fixation latérales 599 agencées pour venir en appui sur deux faces latérales 601 du corps. Le maintien du capot 592 sur le corps se fait par poinçonnage des oreilles latérales 599 au niveau des zones 602.

Le corps 591 du connecteur est réalisé notamment en aluminium, notamment par moulage et usinage, et le capot 592est réalisé en aluminium.

La plaque supérieure 511 comporte trois trous 574 et 580, deux des trous étant associé à des groupes de canaux de même sens de circulation et un trous intermédiaire, entre ces deux trous, qui est associé à un groupe de canaux de fluide de sens opposé, ces trois trous étant notamment alignés. Ces trous sont par exemple sur une région rétrécie 606 de la plaque 511.

## Revendications

1. Dispositif de régulation thermique (50), notamment de refroidissement, pour composant électrique susceptible de dégager de la chaleur lors de son fonctionnement, notamment pour un module de stockage d'énergie électrique, ce dispositif comportant une plaque supérieure (511) et une plaque inférieure (512) assemblée avec la plaque supérieure pour former ensemble une pluralité de canaux (13) de circulation pour un fluide caloporteur, notamment un fluide réfrigérant, notamment un fluide choisi parmi les fluides réfrigérants suivants R134a, R1234yf ou R744, dispositif dans lequel les canaux sont regroupés par groupes de canaux, les canaux d'un groupe s'étendant sensiblement parallèlement les uns aux autres avec un espacement prédéterminé entre canaux voisins appelé espacement intragroupe, deux groupes de canaux ayant un même sens de circulation de fluide étant séparés entre eux par au moins un groupe de canaux ayant un sens de circulation de fluide opposé, le dispositif comportant un connecteur 550) assemblé sur la plaque supérieure ou inférieure, et agencé pour créer un chemin de fluide (551) pour raccorder deux zones collectrices (557), notamment des zones collectrices de sortie, de deux groupes de canaux ayant notamment le même sens de circulation, ces zones collectrices étant formées entre les deux plaques inférieure et supérieure, ce connecteur comportant un orifice externe d'entrée (558) de fluide et un orifice externe de sortie (559) de fluide, l'un de ces deux orifices externes étant en communication de fluide avec le chemin de fluide du connecteur et l'autre des orifice externe étant en communication de fluide avec une zone collectrice de fluide d'un groupe intermédiaire (614) de canaux situé entre les deux groupes de canaux reliés entre eux par le chemin de fluide dans le connecteur, ce groupe intermédiaire ayant notamment un sens de circulation de sens opposé aux deux autres groupes, le ou les groupes de canaux pouvant être, le cas échéant, réduit à un canal, le connecteur comportant en outre deux orifices internes (572) sur lesquels débouchent le chemin de fluide du connecteur, chemin qui en outre communique avec l'un des orifices externes, ces orifices internes étant placés en vis-à-vis respectivement de deux trous dans la plaque, trous qui débouchent de préférence sur les zones collectrices associées, et le connecteur comportant un troisième orifice interne (578) qui communique avec l'autre des orifices externes via un canal dans le connecteur, canal notamment de forme cylindrique, ce troisième orifice interne étant placé de préférence en vis-à-vis d'un trou dans la plaque qui débouche sur la zone collectrice du groupe intermédiaire de canaux.

2. Dispositif selon la revendication 1, **caractérisé en ce que** les orifices internes sont sur une même face (583) du connecteur, face venant en contact avec la plaque, et les orifices externes sont notamment sur une face opposée du connecteur notamment de manière à permettre de raccorder sur ces orifices externes des conduits externes, l'un apportant du fluide et l'autre l'évacuant.

3. Dispositif selon l'une des revendications précédentes, **caractérisé en ce que** le chemin de fluide comporte un tronçon principal perpendiculaire au canal débouchant sur le troisième orifice interne, ce tronçon et ce canal étant séparé l'un de l'autre.

4. Dispositif selon l'une des revendications précédentes, **caractérisé en ce que** le chemin de fluide est formé par une rainure (590) réalisée sur un corps du connecteur et fermé par un capot fixé de manière étanche sur le corps, ce capot étant notamment de forme allongée.

5. Dispositif selon la revendication précédente, **caractérisé en ce que** le capot (592) comporte une plaque agencée pour se loger au moins partiellement dans la rainure, ce capot étant par exemple soudé sur le corps.

6. Dispositif selon l'une des revendications 4 ou 5, **caractérisé en ce que** le capot comporte une patte (595), notamment de forme rectangulaire, se loger dans une encoche de forme complémentaire de la patte.

7. Dispositif selon l'une des revendications 4 à 6, **caractérisé en ce que** le capot comporte deux oreilles de fixation (599) agencées pour venir en appui notamment sur deux faces latérales du corps.

8. Dispositif selon l'une des revendications précédentes, **caractérisé en ce que** le corps du connecteur est réalisé notamment en aluminium, notamment par moulage et usinage, et le capot (592) est réalisé notamment en aluminium.

9. Dispositif selon l'une des revendications précédentes, **caractérisé en ce que** la plaque supérieure comporte trois trous, deux des trous étant associé à des groupes de canaux de même sens de circulation et un trous intermédiaire, entre ces deux trous, qui est associé à un groupe de canaux de fluide de sens opposé, ces trois trous étant notamment alignés.

## Patentansprüche

1. Vorrichtung zur Wärmeregulierung (50), insbesondere zur Kühlung, für ein elektrisches Bauteil, das bei seinem Betrieb Wärme abgeben kann, insbesondere für ein Modul zum Speichern von elektrischer Energie, wobei die Vorrichtung eine obere Platte (511) und eine untere Platte (512) aufweist, die miteinander verbunden sind, um gemeinsam mehrere Zirkulationskanäle (13) für ein Wärmeträgerfluid, insbesondere ein Kühlfluid, insbesondere ein aus den Kühlfluiden R134a, R1234yf oder R744 ausgewähltes Fluid, auszubilden, wobei bei der Vorrichtung die Kanäle zu Kanalgruppen zusammengefasst sind, wobei sich die Kanäle einer Gruppe im Wesentlichen parallel zueinander erstrecken, mit einem vorbestimmten Abstand zwischen benachbarten Kanälen, der als gruppeninterner Abstand bezeichnet wird, wobei zwei Kanalgruppen mit derselben Fluidzirkulationsrichtung durch mindestens eine Kanalgruppe mit einer entgegengesetzten Fluidzirkulationsrichtung voneinander getrennt sind, wobei die Vorrichtung einen Verbinder (550) aufweist, der an der oberen oder der unteren Platte montiert und so angeordnet ist, dass er einen Fluidweg (551) bildet, um zwei Sammelbereiche (557), insbesondere Auslasssammelbereiche, zweier Kanalgruppen mit insbesondere derselben Zirkulationsrichtung zu verbinden, wobei die Sammelbereiche zwischen der unteren und der oberen Platte ausgebildet sind, wobei der Verbinder eine äußere Fluideinlassöffnung (558) und eine äußere Fluidauslassöffnung (559) aufweist, wobei eine der beiden äußeren Öffnungen in fluidischer Verbindung mit dem Fluidweg des Verbinders steht und die andere der äußeren Öffnungen in fluidischer Verbindung mit einem Fluidsammelbereich einer Kanalzwischengruppe (614) steht, die sich zwischen den beiden Kanalgruppen befindet, die durch den Fluidweg im Verbinder miteinander verbunden sind, wobei die Zwischengruppe insbesondere eine Zirkulationsrichtung aufweist, die der der anderen beiden Gruppen entgegengesetzt ist, wobei die Kanalgruppe(n) gegebenenfalls auf einen Kanal reduziert werden können, wobei der Verbinder ferner zwei innere Öffnungen (572) aufweist, in die der Fluidweg des Verbinders mündet, wobei der Weg außerdem mit den äußeren Öffnungen in Verbindung steht, wobei die inneren Öffnungen jeweils gegenüber zwei Löchern in der Platte angeordnet sind, wobei die Löcher vorzugsweise in die dazugehörigen Sammelbereiche münden, und wobei der Verbinder eine dritte innere Öffnung (578) aufweist, die mit den anderen der äußeren Öffnungen über einen Kanal im Verbinder in Verbindung steht, wobei der Kanal insbesondere eine zylindrische Form aufweist, wobei die dritte innere Öffnung vorzugsweise gegenüber einem Loch in der Platte angeordnet ist, das in den Sammelbereich der Kanalzwischengruppe mündet.

2. Vorrichtung nach Anspruch 1, **dadurch gekennzeichnet, dass** die inneren Öffnungen auf einer gleichen Seite (583) des Verbinders liegen, wobei diese Seite mit der Platte in Kontakt kommt, und wobei die äußeren Öffnungen insbesondere auf einer gegenüberliegenden Seite des Verbinders liegen, insbesondere so, dass an diese äußeren Öffnungen äußere Leitungen angeschlossen werden können, von denen eine Fluid zuführt und die andere sie abführt.

3. Vorrichtung nach einem der vorangehenden Ansprüche, **dadurch gekennzeichnet, dass** der Fluidweg einen zum Kanal senkrechten Hauptabschnitt aufweist, der in die dritte innere Öffnung mündet, wobei der Abschnitt und der Kanal voneinander getrennt sind.

4. Vorrichtung nach einem der vorangehenden Ansprüche, **dadurch gekennzeichnet, dass** der Fluidweg durch eine Einkerbung (590) ausgebildet ist, die an einem Körper des Verbinders ausgebildet ist und durch eine dicht am Körper befestigte Kappe verschlossen wird, wobei diese Kappe insbesondere eine längliche Form aufweist.

5. Vorrichtung nach dem vorangehenden Anspruch, **dadurch gekennzeichnet, dass** die Kappe (592) eine Platte aufweist, die so angeordnet ist, dass sie zumindest teilweise in die Einkerbung passt, wobei die Kappe beispielsweise an den Körper angeschweißt ist.

6. Vorrichtung nach einem der Ansprüche 4 oder 5, **dadurch gekennzeichnet, dass** die Kappe eine insbesondere rechteckig geformte Lasche (595) aufweist, die in eine komplementär geformte Aussparung der Lasche passt.

7. Vorrichtung nach einem der Ansprüche 4 bis 6, **dadurch gekennzeichnet, dass** die Kappe zwei Befestigungsohren (599) aufweist, die so angeordnet sind, dass sie insbesondere an zwei Seitenflächen des Körpers zur Anlage kommen.

8. Vorrichtung nach einem der vorangehenden Ansprüche, **dadurch gekennzeichnet, dass** der Körper des Verbinders insbesondere aus Aluminium ausgebildet ist, insbesondere durch Gießen und maschinelle Bearbeitung, und dass die Kappe (592) insbesondere aus Aluminium ausgebildet ist.

9. Vorrichtung nach einem der vorangehenden Ansprüche, **dadurch gekennzeichnet, dass** die obere Platte drei Löcher aufweist, wobei zwei der Löcher Kanalgruppen mit derselben Zirkulationsrichtung zugeordnet sind und ein Zwischenloch zwischen diesen beiden Löchern mit einer Fluidkanalgruppe mit entgegengesetzter Fließrichtung zugeordnet ist, wobei die drei Löcher insbesondere ausgerichtet sind.

## Claims

1. Temperature regulation device (50), notably cooling device, for an electrical component liable to give off heat during operation, notably for an electrical energy storage device, this device having an upper plate (511) and a lower plate (512) joined to the upper plate to together form a plurality of circulation channels (13) for a heat-transfer fluid, notably a refrigerant fluid, notably a fluid selected from the following refrigerant fluids: R134a, R1234yf or R744, in which device the channels are grouped together in groups of channels, the channels of a group extending substantially parallel to one another with a predetermined spacing between neighbouring channels, referred to as intragroup spacing, two groups of channels that have one and the same fluid circulation direction being separated from one another by at least one group of channels that have an opposite fluid circulation direction, the device having a connector (550) joined to the upper or lower plate and designed to create a fluid pathway (551) for connecting two collecting zones (557), notably outlet collecting zones, of two groups of channels having notably the same circulation direction, these collecting zones being formed between the two, upper and lower, plates, this connector having an external inlet orifice (558) for fluid and an external outlet orifice (559) for fluid, one of these two external orifices being in fluidic communication with the fluid pathway of the connector and the other of the external orifices being in fluidic communication with a fluid collecting zone of an intermediate group (614) of channels which is located between the two groups of channels connected to one another by the fluid pathway in the connector, this intermediate group notably having a circulation direction that is the opposite direction to the two other groups, it being possible for the one or more groups of channels to be reduced to one channel if appropriate, the connector moreover having two internal orifices (572) into which the fluid pathway of the connector leads, which pathway moreover communicates with one of the external orifices, these internal orifices being positioned respectively facing two holes in the plate, which holes preferably lead into the associated collecting zones, and the connector having a third internal orifice (578) which communicates with the other of the external orifices via a channel in the connector, which channel is notably cylindrical in shape, this third internal orifice being positioned preferably facing a hole in the plate that leads into the collecting zone of the intermediate group of channels.

2. Device according to Claim 1, **characterized in that** the internal orifices are on one and the same face (583) of the connector, which face comes into contact with the plate, and the external orifices are notably on an opposite face of the connector, notably so as to make it possible to attach external pipes, one supplying fluid and the other removing it, to these external orifices.

3. Device according to either of the preceding claims, **characterized in that** the fluid pathway has a main section perpendicular to the channel leading into the third internal orifice, this section and this channel being separated from one another.

4. Device according to one of the preceding claims, **characterized in that** the fluid pathway is formed by a slot (590) made in a body of the connector and closed by a cover fixed in a fluidtight manner to the body, this cover notably having an elongate shape.

5. Device according to the preceding claim, **characterized in that** the cover (592) has a plate designed to be received at least partially in the slot, this cover being for example welded to the body.

6. Device according to either of Claims 4 and 5, **characterized in that** the cover has a tab (595), notably rectangular in shape, which is received in a cutout of complementary shape to the tab.

7. Device according to one of Claims 4 to 6, **characterized in that** the cover has two fixing lugs (599) designed to bear notably against two lateral faces of the body.

8. Device according to one of the preceding claims, **characterized in that** the body of the connector is made notably of aluminium, notably by casting and machining, and the cover (592) is made notably of aluminium.

9. Device according to one of the preceding claims, **characterized in that** the upper plate has three holes, two of the holes being associated with groups of channels with the same circulation direction, and an intermediate hole, between these two holes, which is associated with a group of fluid channels with the opposite direction, these three holes notably being aligned.
